# DEMANDE DE BREVET EUROPEEN

(11) **EP 1 542 027 A1**
(43) Date de publication de la demande: **15.06.2005**
(21) Numéro de dépôt: 03300264.3
(22) Date de dépôt: 11.12.2003
(51) Int. Cl.: G01R 31/00

(54) **Dispositif de mesure du rayonnement électromagnétique ambiant**

(71) Demandeur: Antennessa, 29280 Plouzane (FR); FRANCE TELECOM, 75015 Paris (FR)
(72) Inventeur: Perrot, Frédéric, 29860 Bourg Blanc (FR); Toutain, Yann, 29280 Locmaria Plouzane (FR); Lattard, Hervé, 29480 Le Relecq Kerhuon (FR); Le Nadan, Thierry, 29200 Brest (FR); Wiart, Joe, 77400 Lagny-sur-Marne (FR)
(74) Mandataire: Grynwald, Albert

(57) **Abrégé**

La présente invention concerne un dispositif (100) de mesure du rayonnement électromagnétique ambiant comprenant des éléments (102, 103) de détection du rayonnement, sur une large bande de fréquences, et des éléments (106, 106₁, 106₂,... 106ₙ) de mesure du niveau de rayonnement sur une bande de fréquences donnée.

Selon l'invention, un tel dispositif est caractérisé en ce qu'il comprend des moyens (104, 104₁, 104₂, ... 104ₙ) de filtrage sélectionnant, dans cette large bande de fréquences, des bandes de fréquences propres à au moins un service de télécommunication et/ou de radiodiffusion afin que les éléments de mesure déterminent le niveau de rayonnement ambiant de ce service en déterminant le niveau de rayonnement de la ou des bande(s) propre(s) à ce service.

## Description

La présente invention se rapporte à un dispositif de mesure du rayonnement électromagnétique ambiant, notamment en fonction de bandes de fréquences correspondant à des services de télécommunication et/ou de radiodiffusion.

Il est connu que l'exposition d'un individu à des champs électromagnétiques peut avoir un impact sanitaire sur cet individu lorsque la puissance de ces champs et/ou la durée d'exposition à ces champs atteignent des seuils donnés.

Dès lors, le développement intense des télécommunications, et notamment des réseaux de téléphonie mobile, engendre des préoccupations relatives aux niveaux d'expositions auxquels sont soumises les personnes présentes dans des zones couvertes par les antennes des services de télécommunications, et ce d'autant plus que ces personnes se situent à proximité des antennes requises pour ces télécommunications.

C'est pourquoi, il apparaît de plus en plus important de pouvoir déterminer le rayonnement électromagnétique auquel est soumis un individu tant sur une courte durée, par exemple lorsque cet individu est un technicien de télécommunication intervenant pendant cette courte durée à proximité d'une antenne, que sur une longue période, par exemple lorsque l'individu considéré réside dans un immeuble à proximité duquel est installée une antenne de télécommunications.

Actuellement, la mesure de l'exposition d'un individu au rayonnement électromagnétique ambiant est effectuée au moyen de deux types distincts d'appareils, à savoir :
i) Les analyseurs de spectre, qui sont des appareils réalisant un nombre important de fonctionnalités telle que celle de permettre la sélection dynamique d'une ou de plusieurs bandes étroites de fréquences, au sein de la large bande de fréquences de réception de l'appareil.
   Dès lors, il est ainsi possible d'analyser individuellement le rayonnement émis par toute bande étroite sélectionnée dans la large bande.
   Cependant, ces appareils présentent les inconvénients d'être relativement coûteux, leur prix étant de l'ordre de 20.000 euros, d'être relativement complexes d'utilisation et de présenter des dimensions importantes qui ne permettent pas leur utilisation comme un dispositif destiné à être porté par un individu.
ii) Les moniteurs portables, qui sont des appareils compacts et mobiles définissant, sur une large bande donnée, le rayonnement électromagnétique auquel est soumis ce détecteur.

A cet effet, il convient de noter que ces moniteurs portables sont généralement conçus pour mesurer l'exposition à un rayonnement sous la forme d'un pourcentage d'exposition sur une large bande de fréquences, par rapport à un seuil d'exposition pouvant être conforme à des recommandations telle(s) que celle(s) de la commission européenne datée du 12 juillet 1999 ou à une norme telle que la norme japonaise Japan RCR-38, comprenant la bande 3 MHz à 60 GHz, ou la norme canadienne Canada Safety Code 699-EHD-237 RF workers, relative au rayonnement compris dans la bande 1MHz à 40 GHz.

La présente invention est issue de l'analyse selon laquelle la connaissance du rayonnement électromagnétique auquel est exposé un individu présente un intérêt accru si ce rayonnement peut être associé à un ou plusieurs services tels que ceux d'un réseau de télécommunications.

Dans ce cas, une personne pourrait connaître les niveaux d'exposition auxquels elle est soumise par différents services, ce qui lui permettrait d'identifier l'origine d'éventuels rayonnements excessifs et de prendre les mesures nécessaires et adéquates pour réduire son exposition à ces sources de rayonnements.

Or, les mesures selon l'art antérieur ne permettent pas d'évaluer les niveaux d'exposition associés à un service de télécommunications utilisant une bande de fréquences spécifique.

L'invention est aussi issue de l'analyse selon laquelle les bandes de fréquences utilisées par les services de télécommunications et/ou de radiodiffusion sont généralement standardisées et/ou normalisées. Dès lors, il est possible de limiter l'analyse du rayonnement ambiant d'un individu aux bandes de fréquences prédéfinies utilisées par ces services pour avoir une connaissance satisfaisante du rayonnement auquel est soumis cet individu.

C'est pourquoi, la présente invention concerne un dispositif de mesure du rayonnement électromagnétique ambiant comprenant des éléments de détection du rayonnement, sur une large bande de fréquences, et des éléments de mesure du niveau de rayonnement sur une bande de fréquences donnée, caractérisé en ce qu'il comprend des moyens de filtrage sélectionnant, dans cette large bande de fréquences, des bandes de fréquences propres à au moins un service de télécommunication et/ou de radiodiffusion afin que les éléments de mesure déterminent le niveau de rayonnement ambiant de ce service en déterminant le niveau de rayonnement de la ou des bande(s) propre(s) à ce service.

Un tel dispositif présente l'avantage de pouvoir être mis en oeuvre à l'aide d'un nombre limité de composants électroniques relativement simples, permettant ainsi au dispositif d'être compact et léger, et par conséquent aisément portable.

De plus, son utilisation individuelle, par exemple par des employés d'un opérateur de télécommunication et, d'une façon générale, par toute personne désirant connaître le niveau de rayonnement électromagnétique auquel il est soumis, est facilement mise en oeuvre car la mesure du rayonnement ne requiert aucune intervention de la personne portant ce dispositif.

Le dispositif présente aussi l'avantage de pouvoir être mis en oeuvre au moyen de composants électroniques dont le coût est relativement réduit, de telle sorte que l'appareil présente lui-même un coût limité.

Finalement, l'invention présente l'avantage de permettre la détermination du niveau et de l'origine du rayonnement électromagnétique auquel est soumis un individu en fonction d'un service donné de telle sorte que, si ce rayonnement s'avère excessif, des mesures nécessaires à la diminution de ce rayonnement peuvent être aisément envisagées.

Dans une réalisation, le dispositif détecte le rayonnement sur une large bande de fréquences allant de 6 Mhz à 6 Ghz. Une telle bande permet actuellement de couvrir l'ensemble des services de télécommunications et de radiodiffusion, étant entendu que l'invention peut s'appliquer sur toute bande nécessaire à couvrir les services dont le rayonnement est mesuré.

Selon une réalisation, le dispositif comprend un élément de contrôle de la puissance du rayonnement reçu situé entre les éléments de détection et les éléments de filtrage, cet élément pouvant être un atténuateur ou un amplificateur.

Ainsi, il est possible de fabriquer en série des éléments de détection et de filtrage communs à des dispositifs destinés à être soumis à différents niveaux de rayonnement, l'adaptation du dispositif à ces différents niveaux s'effectuant grâce à l'élément de contrôle de la puissance.

Dans une réalisation, les moyens de filtrage comprennent des interrupteurs.

Selon une réalisation, le dispositif comprend des moyens de traitement du signal lié au niveau de rayonnement, par exemple en numérisant ce signal en vue d'un traitement par ordinateur. Dès lors, l'exploitation des niveaux détectés de rayonnement est aisément réalisable.

Dans une réalisation, le dispositif comprend des moyens de traitement du signal afin de comparer le niveau de rayonnement détecté dans une bande étroite par rapport à un seuil de rayonnement, et/ou des moyens pour stocker les niveaux de rayonnement détectés.

Selon une réalisation, les éléments de détection comprennent une pluralité d'antennes.

Dans ce cas, dans une réalisation, les antennes sont agencées de telle sorte que la mesure du rayonnement soit isotrope.

Dans une réalisation, au moins une antenne distante est reliée au dispositif, par exemple au moyen d'un câble, d'une fibre optique ou d'une liaison radio.

Selon une réalisation, les éléments de mesure déterminent le niveau de rayonnement d'une ou de plusieurs bande(s) propres à un service en générant un signal continu dont la tension ou l'intensité est fonction, par exemple proportionnelle, à la puissance transmise par cette ou ces bande(s).

Dans une réalisation le dispositif comprend des moyens pour considérer les télécommunications d'un terminal vers une base comme un service distinct vis-à-vis des télécommunications de cette base vers ce terminal.

Selon une réalisation, le dispositif comprend des moyens pour considérer des services de télécommunications selon l'une des normes ou standard suivants : Global System for Mobile Communication (GSM), GSM 900, GSM 1800, Nordic Mobile Téléphone, Universal Mobile Télécommunication System (UMTS), l'Advanced Mobile Phone System (AMPS), Terrestrial Trunked Radio (Tetra), ou une norme ou standard de téléphonie sans fil telle que Wireless Local Area Network (WLAN) ou Wireless-Fidelity (WI-FI).

Dans une réalisation, le dispositif comprend des moyens pour appliquer différents protocoles ou manières de mesure du rayonnement d'une ou plusieurs bande(s) de fréquences sélectionnées en fonction, par exemple, de la nature du service considéré, ces manières pouvant notamment varier vis-à-vis de la durée et du nombre de périodes de mesures.

D'autres caractéristiques et avantages de l'invention apparaîtront avec la description effectuée ci-dessous, à titre illustratif et non limitatif, d'un mode de réalisation préféré de l'invention à l'aide des figures ci-jointes sur lesquelles :
la figure 1 est un schéma fonctionnel d'un dispositif conforme à l'invention,
la figure 2 est un diagramme de bandes de fréquences propres à diverses applications et/ou services de télécommunications et/ou radiodiffusions, et
la figure 3 est un schéma électronique d'un dispositif conforme à l'invention.

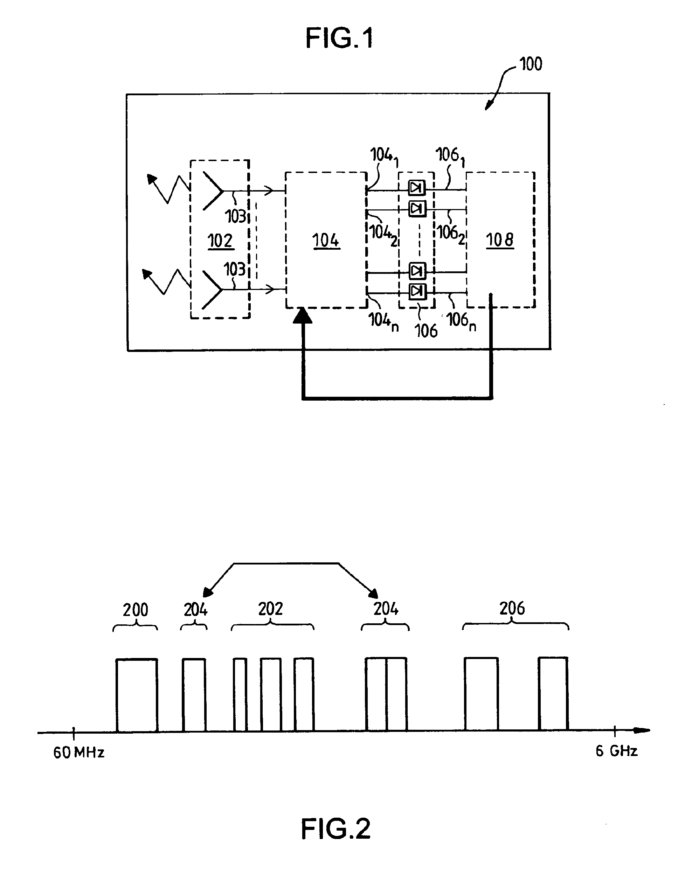

Un dispositif 100 (figure 1) de détection du rayonnement ambiant conforme à l'invention peut comprendre un premier bloc 102 comprenant des éléments de détection des rayonnements électromagnétiques devant être mesurés selon différentes bandes de fréquences.

A cet effet, ces éléments peuvent comprendre plusieurs antennes 103 détectant le rayonnement électromagnétique sur une large bande de fréquences, par exemple allant de 10 MHz à 6 GHz.

Dans la réalisation décrite, ces antennes 103 sont incluses dans le dispositif mais, selon d'autres réalisations, une ou plusieurs de ces antennes peuvent être situées à l'extérieur du dispositif.

Dans ce dernier cas, la ou les antennes extérieures sont reliées au dispositif 100 au moyen d'un câble, d'une fibre optique ou d'une liaison radio.

Le rayonnement détecté par la ou les antennes 103 est transmis à un bloc 104 comprenant des moyens de filtrage, des interrupteurs et d'éventuels amplificateurs visant à séparer des bandes étroites de fréquences, correspondant à des service s de télécommunication, dans l'ensemble de la large bande reçue par les antennes.

Par la suite, chaque bande de fréquences ainsi traitée est émise par une des sorties 104₁, 104₂... 104ₙ du bloc 104 vers une des entrées correspondantes d'un bloc 106 de transformation destiné à générer des signaux électriques continus liés, par exemple proportionnellement, à la puissance de rayonnement associée à chaque bande filtrée.

Ainsi, à partir de chacune des bandes filtrées reçues, le bloc 106 transmet à un bloc 108 de traitement un signal correspondant 106₁, 106₂, ...ou 106ₙ continu dont la tension ou l'intensité est fonction de la puissance de rayonnement de cette bande filtrée.

Grâce à ces signaux 106ᵢ, le bloc 108 de traitement peut analyser le rayonnement ambiant de façon à déterminer, par exemple, la valeur de rayonnement d'une application et/ou d'un service par rapport à une valeur seuil.

Le bloc 108 peut aussi stocker des informations relatives à ces signaux, par exemple dans le cadre d'une étude requérant des mesures sur différentes périodes.

Par ailleurs, le bloc 108 peut comprendre des moyens, tels que des logiciels, lui permettant d'appliquer différentes manières pour déterminer le niveau du rayonnement émis dans une bande de fréquences en fonction, par exemple, de la nature du service considéré.

Ainsi, lorsque le service considéré met en oeuvre un rayonnement de puissance continue, comme un service d'émission radio modulée en fréquence (radio FM), la mesure de cette puissance sur une courte période est suffisante pour déterminer la puissance de rayonnement de ce service.

Inversement, lorsque le service considéré utilise des rayonnements de puissance variable, tel que lors d'une télécommunication selon la norme de téléphonie mobile GSM (Global System for Mobile communications), il s'avère nécessaire d'effectuer des mesures sur des périodes statistiquement déterminées afin d'obtenir une mesure globale du rayonnement émis par ce service.

Aussi, comme représenté sur la figure 1, le bloc 108 peut exercer un contrôle sur le bloc 104 de filtrage afin d'adapter ce filtrage et les éventuels amplifications aux niveaux de puissances détectés.

A ce stade, il convient de signaler que le bloc 104, effectuant le filtrage d'une large bande de fréquences pour obtenir une pluralité de bandes de fréquences étroites relatives à des services, est nécessaire pour mettre en oeuvre l'invention puisqu'il filtre un signal de bande de fréquences larges pour fournir des signaux de bandes de fréquences étroites qui sont relatives à des services utilisant ces bandes de fréquences étroites.

De même, il convient de signaler que l'invention s'applique à la mesure de rayonnement relatif à un service pouvant être dû à une activité autre que des télécommunications, tels que des activités de radiodiffusion (télévision).

Par ailleurs, lorsque les activités de télécommunications sont considérées, ces dernières peuvent être relatives à différentes bandes de fréquences, notamment en fonction du protocole mis en oeuvre par ces télécommunications.

Ainsi, sur la figure 2 est représenté un exemple de bandes de fréquences 200, 202, 204 et 206, pouvant être traitées par un dispositif 100 conforme à l'invention, ces diverses bandes de fréquences étant mesurées sur une large bande de fréquences allant de 60 Mhz à 6 Ghz.

La bande de fréquences 200 est constituée d'une bande de fréquences continue pouvant correspondre, par exemple, à des services d'émission radiophonique en modulation de fréquence (radio FM). En d'autres termes, la bande 200 comprend l'ensemble des rayonnements détectés dus à cette activité.

La bande 202 de fréquences 202 est constituée de 3 sous-bandes transmettant des informations complémentaires. Une telle transmission est, par exemple, utilisée dans les transmissions relatives à des signaux de télévision.

La bande 204, propre à un service de télécommunication mobile, est constituée de deux sous-bandes juxtaposées, chacune des sous-bandes étant relative à la transmission d'informations selon un sens terminal-station ou station terminal, ainsi que d'une troisième bande distincte des deux premières sous bandes de telle sorte que les bandes 202 sont intercalées entre les bandes 204.

Finalement, la bande 206 comprend deux sous-bandes distinctes pour chacun des sens d'émissions terminal-station ou station-terminal.

A ce stade, il convient de signaler que l'invention permet, dans une réalisation, de déterminer l'exposition au rayonnement en fonction du sens d'émission terminal-station ou station-terminal.

Ainsi, il est possible de déterminer la composante de rayonnement propre à une utilisation ponctuelle du service (sens terminal-station) par rapport à une composante continue de ce rayonnement (sens station-terminal).

Finalement, il convient aussi de signaler que les bandes de fréquences considérées peuvent être relatives, par exemple, aux bandes de fréquences normalisées pour des communications selon des standards ou des normes tels que Global System for Mobile Communication (GSM), GSM 900, GSM 1800, Nordic Mobile Telephone, Universal Mobile Telecommunication System (UMTS), l'Advanced Mobile Phone System (AMPS), Terrestrial Trunked Radio (Tetra), ou une norme ou standard de téléphonie sans fil telle que Wireless Local Area Network (WLAN) ou Wireless-Fidelity (WI-FI).

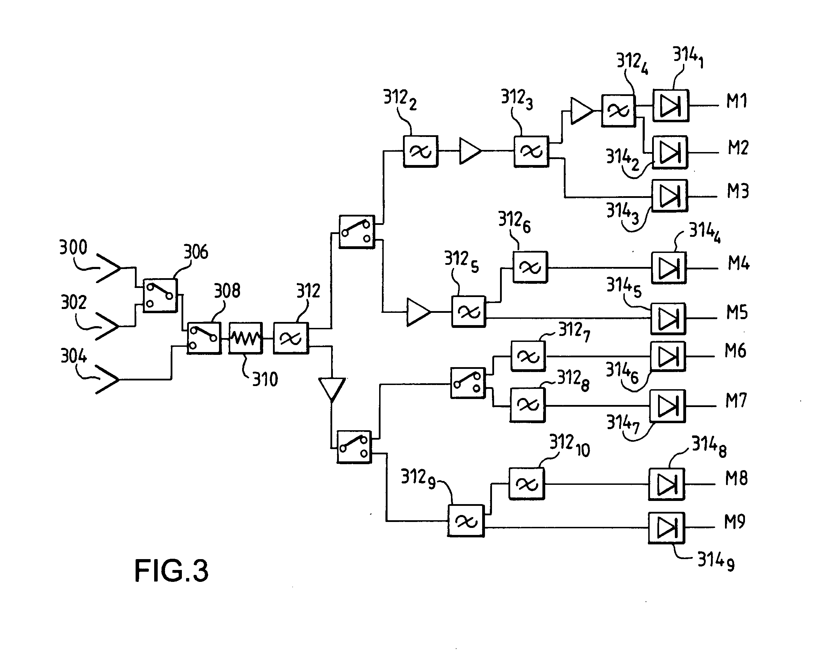

Sur la figure 3 est représenté un schéma électrique d'un appareil conforme à l'invention.

Selon ce schéma, la fonction de réception est effectuée au moyen de trois antennes 300, 302 et 304, des commutateurs 306 et 308 permettant sélectivement de transmettre par la suite le signal reçu par l'une de ces antennes.

L'utilisation de trois antennes, telles que décrites dans cet exemple de réalisation de l'invention, permet de considérer que ces antennes se comportent comme un récepteur isotrope de rayonnement électromagnétique.

Le niveau du champ capté par ces antennes est ensuite traité par un élément 310 de contrôle de puissance permettant d'adapter la puissance reçue par les antennes à un niveau propre à la fonction considérée.

De fait, un appareil destiné au grand public est conçu pour être soumis à des rayonnements d'intensité moindre qu'un appareil destiné, par exemple, à des réparateurs d'antennes.

En d'autres termes, en utilisant un élément 310 distinct pour un appareil grand public et pour un appareil destiné à des professionnels, il est possible d'implémenter des éléments communs de filtrage, de conversion et de traitement du rayonnement dans tous ces appareils car un niveau d'énergie équivalent est délivré en sortie de cet élément 310.

Typiquement, l'élément 310 est un atténuateur lorsque l'appareil est utilisé par des professionnels pouvant s'approcher des sources de rayonnement tandis que cet élément 310 est un amplificateur lorsque cet appareil est destiné au grand public.

Par la suite, une série de filtre 312₁, 312₂, 312₃, ...312₁₀ permet de sélectionner une bande étroite de fréquences, propre à un service et/ou à une application, dans la bande de fréquences détectée pour amener sélectivement cette bande étroite sur une des diodes 314ᵢ qui fournissent un signal 316ᵢ dont la tension est fonction de l'intensité du rayonnement reçu dans la bande de fréquences étroite sélectionnée.

Ainsi, le dispositif délivre à chacune de ces sorties M₁, M₂, ... M₉ un signal 316ᵢ significatif du rayonnement détecté par le dispositif dans le cadre d'un service et/ou d'une application utilisant un rayonnement électromagnétique.

Un signal 316ᵢ, qui se présente sous la forme d'une tension continue, peut être traitée de différentes manières par la suite.

Selon une réalisation, ce signal analogique 316ᵢ est numérisé et stocké de façon à permettre son traitement, par exemple par un ordinateur. Une telle réalisation permet d'obtenir des suivis d'exposition selon des périodes distinctes, de les comparer et de conclure à d'éventuelles variations.

Dans une autre réalisation, le signal 316ᵢ est utilisé en relation avec un condensateur dont la capacité est telle que, lorsque l'énergie reçue par cette capacité atteint un certain seuil, le condensateur déclenche l'activation d'un indicateur, tel qu'une diode, pour signaler qu'un seuil d'exposition a été atteint.

Il est important de noter que la mise en oeuvre de l'invention présentée ci-dessus effectue la détection d'un niveau de rayonnement à partir de la fréquence détectée, sans intervention d'une fréquence intermédiaire de traitement, comme réalisé par un analyseur de spectre.

Une telle mise en oeuvre simplifie le dispositif en le rendant plus compact et moins coûteux.

Finalement, l'invention concerne un procédé de fabrication d'un dispositif conforme à l'invention ainsi que toute mise en oeuvre ou utilisation de ce dispositif dans la mesure d'une exposition à un rayonnement électromagnétique.

## Revendications

1. Dispositif (100) de mesure du rayonnement électromagnétique ambiant comprenant des éléments (102, 103, 300, 302, 304) de détection du rayonnement, sur une large bande de fréquences, et des éléments (106, 106₁, 106₂, ... 106ₙ, 314ᵢ) de mesure du niveau de rayonnement sur une bande de fréquences donnée, **caractérisé en ce qu'**il comprend des moyens (104, 104₁, 104₂, ... 104ₙ, 312₁, 312₂, ... 312₁₀) de filtrage sélectionnant, dans cette large bande de fréquences, des bandes (200, 202, 204, 206) de fréquences propres à au moins un service de télécommunication et/ou de radiodiffusion afin que les éléments de mesure déterminent le niveau de rayonnement ambiant de ce service en déterminant le niveau de rayonnement de la ou des bande(s) propre(s) à ce service.

2. Dispositif selon la revendication 1 **caractérisé en ce qu'**il détecte le rayonnement sur une large bande de fréquences allant de 6 Mhz à 6 Ghz.

3. Dispositif selon la revendication 1 ou 2 **caractérisé en ce qu'**il comprend un élément (310) de contrôle de la puissance du rayonnement reçu situé entre les éléments de détection et les éléments de filtrage, cet élément pouvant être un atténuateur ou un amplificateur.

4. Dispositif selon la revendication 1, 2 ou 3 **caractérisé en ce que** les moyens (104, 104₁, 104₂, ... 104ₙ, 312₁, 312₂, ... 312₁₀) de filtrage comprennent des interrupteurs (306, 308) associés à des filtres (312₁, 312₂, ... 312₁₀).

5. Dispositif selon l'une des revendications 1 à 4 **caractérisé en ce que** le dispositif comprend des moyens de traitement du signal lié au niveau de rayonnement, par exemple en numérisant ce signal en vue d'un traitement par ordinateur.

6. Dispositif selon la revendication 5 **caractérisé en ce qu'**il comprend des moyens (108) de traitement du signal afin de comparer le niveau de rayonnement détecté dans une bande étroite par rapport à un seuil de rayonnement, et/ou des moyens pour stocker les niveaux de rayonnement détectés.

7. Dispositif selon l'une des revendications 1 à 6 **caractérisé en ce que** les éléments de détection comprennent une pluralité d'antennes (103, 300, 302, 304).

8. Dispositif selon la revendication 7 **caractérisé en ce que** les antennes (103, 300, 302, 304) sont agencées de telle sorte que la mesure du rayonnement soit isotrope.

9. Dispositif selon l'une des revendications précédentes **caractérisé en ce qu'**au moins une antenne distante est reliée au dispositif, par exemple au moyen d'un câble, d'une fibre optique ou d'une liaison radio.

10. Dispositif selon l'une des revendications précédentes **caractérisé en ce que** les éléments (106, 106₁, 106₂, ... 106ₙ, 314ᵢ) de mesure déterminent le niveau de rayonnement d'une ou de plusieurs bande(s) (200, 202, 204, 206) propres à un service en générant un signal continu dont la tension ou l'intensité est fonction, par exemple proportionnelle, à la puissance transmise par cette ou ces bande(s).

11. Dispositif selon l'une des revendications précédentes **caractérisé en ce qu'**il comprend des moyens pour considérer les télécommunications d'un terminal vers une base comme un service distinct vis-à-vis des télécommunications de cette base vers ce terminal.

12. Dispositif selon l'une des revendications précédentes **caractérisé en ce qu'**il comprend des moyens pour considérer des services de télécommunications selon l'une des normes ou standard suivants : Global System for Mobile Communication (GSM), GSM 900, GSM 1800, Nordic Mobile Telephone, Universal Mobile Télécommunication System (UMTS), l'Advanced Mobile Phone System (AMPS), Terrestrial Trunked Radio (Tetra), ou une norme ou standard de téléphonie sans fil telle que Wireless Local Area Network (WLAN) ou Wireless-Fidelity (WI-FI).

13. Dispositif selon l'une des revendications précédentes **caractérisé en ce qu'**il comprend des moyens pour appliquer différents protocoles ou manières de mesure du rayonnement d'une ou plusieurs bande(s) de fréquences sélectionnées en fonction, par exemple, de la nature du service considéré, ces manière s pouvant notamment varier vis-à-vis de la durée et du nombre de périodes de mesures.
